(19) Europäisches Patentamt
European Patent Office
Office européen des brevets

(11) **EP 1 780 815 A2**

(12) **EUROPEAN PATENT APPLICATION**

(43) Date of publication:
**02.05.2007 Bulletin 2007/18**

(51) Int Cl.:
*H01L 51/00* (2006.01)   *H01L 51/05* (2006.01)
*H01L 51/10* (2006.01)

(21) Application number: **06021020.0**

(22) Date of filing: **06.10.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **31.10.2005 JP 2005317486**

(71) Applicant: **FUJI ELECTRIC HOLDINGS CO., LTD.**
**Kawasaki-shi,**
**Kanagawa 210-0856 (JP)**

(72) Inventors:
• **Kawakami, Haruo**
**1 Fuji-machi**
**Hino-shi**
**Tokyo 191-8502 (JP)**

• **Kato, Hisato**
**1 Fuji-machi**
**Hino-shi**
**Tokyo 191-8502 (JP)**
• **Maeda, Takahiko**
**1 Fuji-machi**
**Hino-shi**
**Tokyo 191-8502 (JP)**
• **Sekine, Nobuyuki**
**1 Fuji-machi**
**Hino-shi**
**Tokyo 191-8502 (JP)**

(74) Representative: **Hoffmann, Eckart**
**Patentanwalt,**
**Bahnhofstrasse 103**
**82166 Gräfelfing (DE)**

(54) **Organic thin film transistor and manufacturing method thereof**

(57)    An OTFT is provided which is characterized by including a substrate (10) having therein a groove and one of a groove and a hole, a source electrode (15) filling the one of the groove and the one of the groove and the hole, a drain electrode (14) filling the other one of the groove and the one of the groove and the hole, a film (13) of organic semiconductor material formed on the source electrode (15) and the drain electrode (14) for making electrical contact therewith, a gate insulating film (12) formed on the film (13) of organic semiconductor material, and a gate electrode (11) formed on the gate insulating film (12). A method of manufacturing the OTFT allows realization of high precision microfabrication of the source electrode (15) and the drain electrode (14) formed on the substrate (10) such as a plastic substrate (10) by an inexpensive process for stable realization of high performance.

## FIG. 1A

EP 1 780 815 A2

**(Cont. next page)**

## FIG. 1B

## FIG. 1C

## FIG. 1D

**Description**

The present invention relates to a thin film transistor element using organic semiconductor material and a manufacturing method thereof.

In recent years, flat displays for information equipment have become remarkably widespread. Liquid crystal displays represent one kind of flat displays, in which light from a backlight is on-off controlled by an optical shutter function of a liquid crystal and colored light is obtained by means of a color filter. Compared with this, in an organic EL (Electroluminescent) display (or an organic LED (Light-Emitting Diode) display) as another kind of flat displays, light is presented by individual light emission of each of pixels (i.e. by spontaneous light emission of each pixel). Therefore, an organic EL display has the merit of not only providing a wide viewing angle but also requiring no backlight. This allows the display to have a number of advantages such as to enable the display to be provided as a thin display and to be formed on a flexible substrate. Thus, EL displays are expected to become the next-generation displays.

The driving systems of the panel for such a display may be roughly classified into two types. A first type of driving system is referred to as a passive matrix type (also called duty driving system or simple matrix system). In this system, a plurality of stripe-shaped electrodes are arranged in rows and in columns in a matrix-like shape. At each intersection of a row electrode and a column electrode a pixel is formed that is made to emit light by driving signals applied to the row electrode and the column electrode, respectively. Normally, the row electrodes are scanned, i.e., the row electrodes are individually selected by a signal in time sequence for light-emission control of the pixels in the respective row. While a certain row electrode is selected, to all of the column electrodes, their respective signals for light-emission control in the selected row are simultaneously applied. The system is normally provided with no active element for each of the pixels so as to carry out light-emission control only in the duty period of each row within the scanning period of all rows.

A second kind of driving system is referred to as an active matrix type in which each of a plurality of pixels has a switching element associated therewith that allows the pixel to emit light throughout the scanning period of all rows. For example, suppose a case in which the whole panel with pixels of 100 rows and 150 columns is made to emit light with a displaying luminance of $100Cd/m^2$. In this case, in a panel of the active matrix type each of the pixels basically always emits light. Hence, a pixel can be made to emit light with a luminance of $100Cd/m^2$ when the area factor and various kinds of losses of the pixel are not taken into consideration. In a panel of the passive matrix type with the same pixel arrangement, however, the duty ratio of a signal driving each of the pixels becomes 1/100 and only the duty period (selection period) is given as the time of light-emission. Therefore, for obtaining the same displaying luminance as that in the panel of the active matrix type, a luminance of light-emission in the light-emitting time of a pixel must be increased by a factor of 100 to be $10000Cd/m^2$.

For increasing the luminance of light-emission, the current made to flow in a light-emitting element may be increased. However, in an organic EL light-emitting element, it is known that the light-emission efficiency is lowered as the current is increased. The lowered efficiency causes the power consumption in the passive matrix type to be larger than that in the active matrix type when the displaying luminance levels are the same in both cases. Moreover, an increase in the current flowing in an organic EL element causes inconvenience of making the material of the EL element liable to be deteriorated due to the generated heat to shorten the life time of the display device. A current whose maximum value is limited from the view point of enhancing the efficiency and the life time results in the requirement for a lengthened light-emitting period for obtaining the same displaying luminance. The lengthened light-emitting period, however, results in a limitation of the displaying capacity (the number of driving lines) because the duty ratio determining the time of light-emission in the passive matrix type driving system is the reciprocal of the number of rows in a panel. Under these circumstances, the realization of a panel with a large area and a high resolution necessitates the use of an active matrix type driving system.

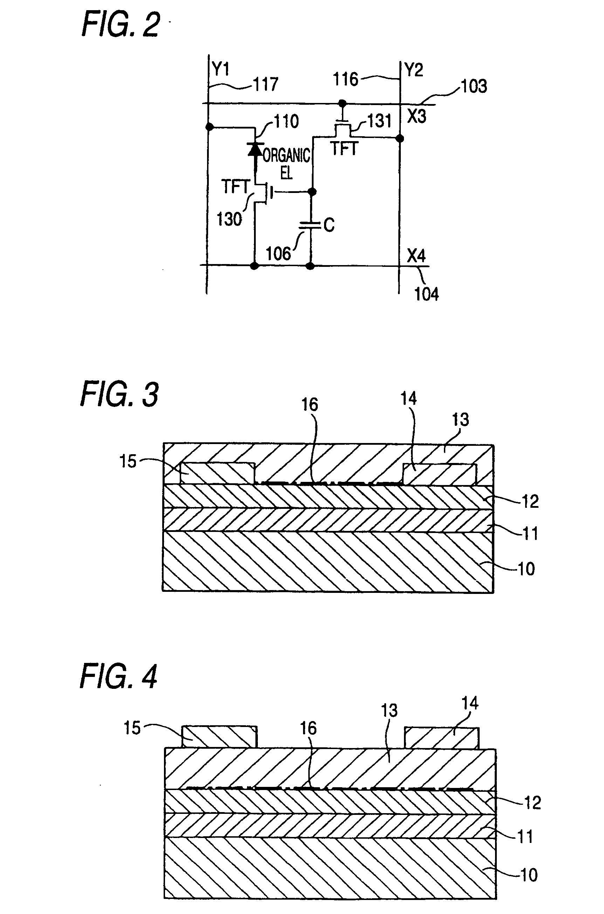

A basic example of a light-emitting element control circuit for an ordinary active matrix type driving system is known as a circuit using thin film transistors as switching elements as shown in FIG. 2.

In the circuit shown in FIG. 2, the source of a driving thin film transistor 130 is connected to a light-emitting element (an organic EL element) 110 connected to a second column electrode 117. The driving thin film transistor 130 has its drain connected to a second row electrode 104 and its gate connected to the source of a switching transistor 131. The source of the switching transistor 131 is also connected to the second row electrode 104 through a capacitor 106. Furthermore, the drain and the gate of the switching transistor 131 are connected to a first column electrode 116 and a first row electrode 103, respectively.

In an active matrix type driving system suited for a displaying panel with a large area and high fineness, a thin film transistor (TFT) using polysilicon is most widely used as a switching element of a pixel. However, the process for forming a TFT using polysilicon requires a high temperature of 250°C or more, for example. Thus, a problem is presented in that it is difficult to use a flexible plastic substrate without sufficient heat resistance.

In order to counter such various kinds of problems presented in prior art display panels, the use of an organic thin film transistor (OTFT has long been proposed.

For example, JP-A-2001-250680 discloses an organic thin film rectifying element that is connected in series to an organic thin film light-emitting section. In addition, WO-01/15233 discloses a drive control of a pixel that is carried out by an OTFT. According to the disclosure of WO-01/15233, a driving element formed with organic material enables the manufacturing process thereof to be carried out at a low temperature to thereby allow the use of a flexible plastic substrate. Moreover, in manufacturing the driving element, low cost material and a low cost process can be selected to enable cost reduction of a display panel.

However, such an OTFTs involve the following problems.

Typical structures of OTFTs may be roughly classified into a structure referred to as bottom contact structure as shown in FIG. 3, a structure referred to as top contact structure as shown in FIG. 4, and a structure referred to as top gate structure as shown in FIG. 10.

In the bottom contact structure, a source electrode 15 and a drain electrode 14 are formed on a gate insulating film 12 directly or with a bonding layer put in between. Thereafter, a film of organic semiconductor material 13 is formed thereon to provide the structure. In a top contact structure, a film of organic semiconductor material 13 is formed on a gate insulating film 12 before a source electrode 15 and a drain electrode 14 are formed thereon. In each of the two structures, a gate electrode 11 is formed on the side of the substrate 10 (bottom gate).

In a top gate structure, a film of organic semiconductor material 13 is formed on the surface of a substrate 10, a gate insulating film 12 is formed on the film 13 and a gate electrode 11 is formed on the surface of the gate insulating film 12semiconductor. The top gate structure is particularly often used when the film of organic semiconductor material 13 is made of polymer material of an amorphous structure with a smooth surface.

In each structure, by applying a gate voltage to the gate electrode 11, electric charge carriers are induced in the film of organic semiconductor material 13 at a section in contact with the gate insulating film 12. The induced carriers are made to move by applying a voltage between the source electrode 15 and the drain electrode 14, by which a current flows. The current path between the source electrode 15 and the drain electrode 14 is referred to as a channel. The channel is usually formed at a very thin section with several molecular layers of the film of organic semiconductor material 13 in contact with the gate insulating film 12.

Examples of the organic semiconductor material used for an OTFT are materials such as pentacene, thiophen polymer, fluorene-thiophene polymer, copper phthalocyanine and fullerane. Of these materials, in particular, low polymer materials such as pentacene, copper phthalocyanine and fullerane are not soluble in a solvent at room temperature, so that they are generally formed by vacuum evaporation. Compared with this, thiophene polymer and fluorene-thiophene polymer are soluble in a solvent, so that they can be formed into a thin film by coating. Therefore, no vacuum process is necessary in this case to enable further cost reduction.

However, the mobility of carriers in the organic semiconductor materials is limited to 8cm$^2$/Vs or less even in pentacene with the highest mobility. This is small compared with a mobility of 10 to 100cm$^2$/Vs of polysilicon used in TFTs for driving organic EL displays at present. In particular, the mobility in polymer material that can be formed as a thin film by coating is even smaller and a value of 0.1 cm$^2$/Vs or less is reported.

For example, the saturation current Isd of a field-effect transistor is generally expressed by the following expression:

$$Isd = (W/2L) * C * \mu * (Vg - Vth)^2. \qquad (1)$$

Here, W and L are the channel width and the channel length of the transistor, respectively, C is capacitance per unit area of the gate insulating film, $\mu$ is the carrier mobility in the material, Vg is the gate voltage and Vth is the threshold value of the gate voltage. For obtaining a sufficiently large Isd under a certain voltage condition, C and $\mu$ are desired to be large. However, C and $\mu$ are physical property values inevitably determined by the material being used. The channel width W is limited by the area for forming the element. On the other hand, the channel length L can be minimized theoretically down to 10nm by means of, for example, photolithography. Thus, by minimizing the channel length L, a large saturation current Isd can be obtained even with a material with a small carrier mobility.

However, for obtaining a small channel length L, an expensive process is necessary. For example, an ordinary photo process, though it has a high working accuracy, generally requires high costs. Particularly for obtaining a high working accuracy of several micrometers or less, a highly expensive facility is necessary.

Moreover, with electrically conductive material that can be particularly formed into a thin film by coating, electrodes were sometimes formed by various kinds of printing (IJP, padding, flexographic printing and gravure printing, for example). However, the limit of dimensional accuracy obtained in these methods was approximately 20µm, which made it difficult to accurately obtain a channel length of 10µm or less that was necessary for achieving the above purpose.

In addition to this, when an inexpensive plastic substrate is particularly used as a substrate, the large thermal expansion coefficient of the substrate makes it difficult to match positions of patterns formed in patterning process steps different from one another. The dimensional accuracy of the channel width W as well as that of the channel length L directly affect characteristics of the transistor. Therefore, at least the source electrode 15 and the drain electrode 14 were desired to be accurately formed by a method with high reproducibility that is carried out at one time patterning process step.

Therefore, for taking advantage of an organic material, a measure has been strongly desired for forming an OTFT at a low cost with high dimensional accuracy.

It is an object of the present invention to provide an organic thin film transistor and a method of manufacturing that is inexpensive and allows realization of a high precision microfabrication of a source electrode and a drain electrode formed on a substrate such as a plastic substrate.

The invention has been made to solve the foregoing problem. Namely, for achieving the object, a TFT according to the invention is characterized by including a substrate having therein two recesses, preferably a groove and either another groove or a hole, a source electrode filling the one of these recesses, a drain electrode filling the other one of the recesses, an organic semiconductor film, i.e., a film of an organic semiconductor material, formed on the source electrode and the drain electrode so as to make electrical contact therewith, a gate insulating film formed on the organic semiconductor film , and a gate electrode formed on the gate insulating film.

A method of manufacturing a TFT according to the invention is characterized by including the steps of forming two recesses, a groove and either another groove or a hole, in a substrate, forming one of a source electrode and a drain electrode in one of the recesses, forming the other one of the source electrode and the drain electrode in the other recess, and forming an organic semiconductor film , a gate insulating film, and a gate electrode in this order on the substrate with the source electrode and the drain electrode formed therein.

The invention allows an OTFT to be realized by high precision microfabrication of a source electrode and a drain electrode formed in a substrate such as a plastic substrate by an inexpensive process for stable realization of high performance. In addition, a matrix-like wiring to the source electrode and the drain is facilitated and a leak current from the element of the transistor reduced.

In the following preferred embodiments of the present invention will be explained in detail with reference to attached drawings, in which:

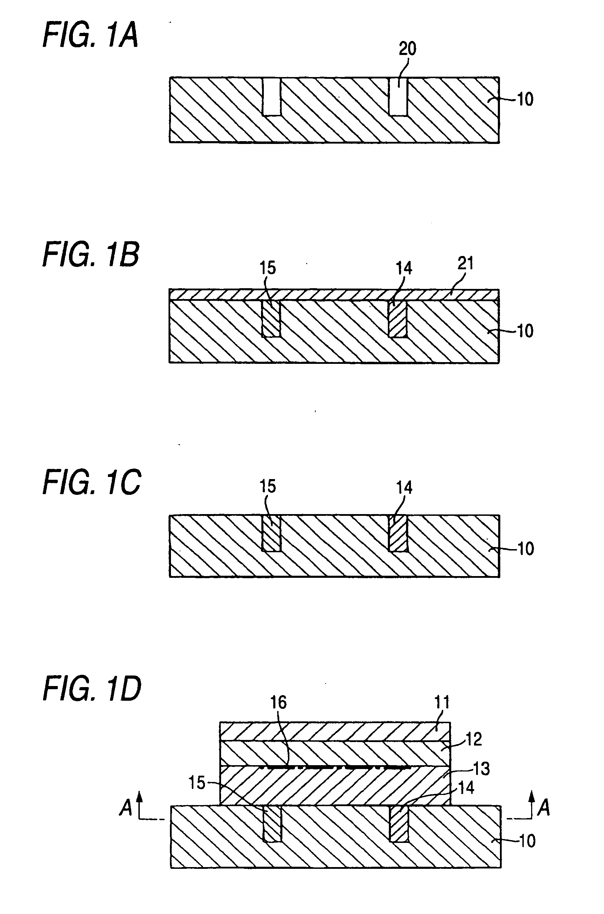

FIGS. 1A to 1D     are cross sectional views showing a first embodiment of the TFT according to the invention about the structure and the manufacturing steps thereof;

FIG. 2     is a circuit diagram showing an example of a basic circuit of a light-emitting element control circuit for an ordinary active matrix type driving system using TFTs;

FIG. 3     is a cross sectional view showing an example of a structure (bottom contact) of a related OTFT;

FIG. 4     is a cross sectional view showing an example of a structure (top contact) of a related OTFT;

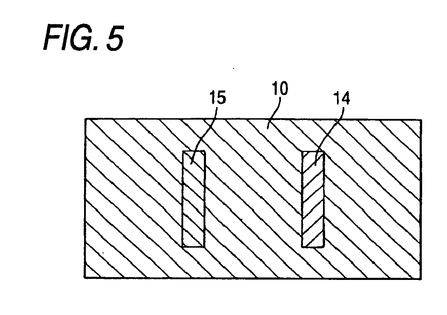

FIG. 5     is a cross sectional plan view taken on line A - A of FIG. 1D;

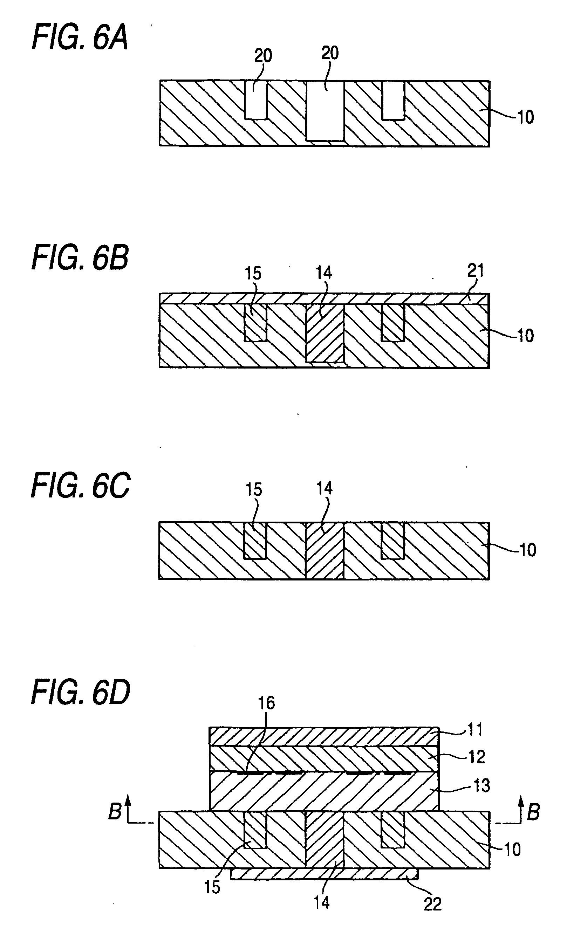

FIGS. 6A to 6D     are cross sectional views showing a second embodiment of the TFT according to the invention about the structure and the manufacturing steps thereof;

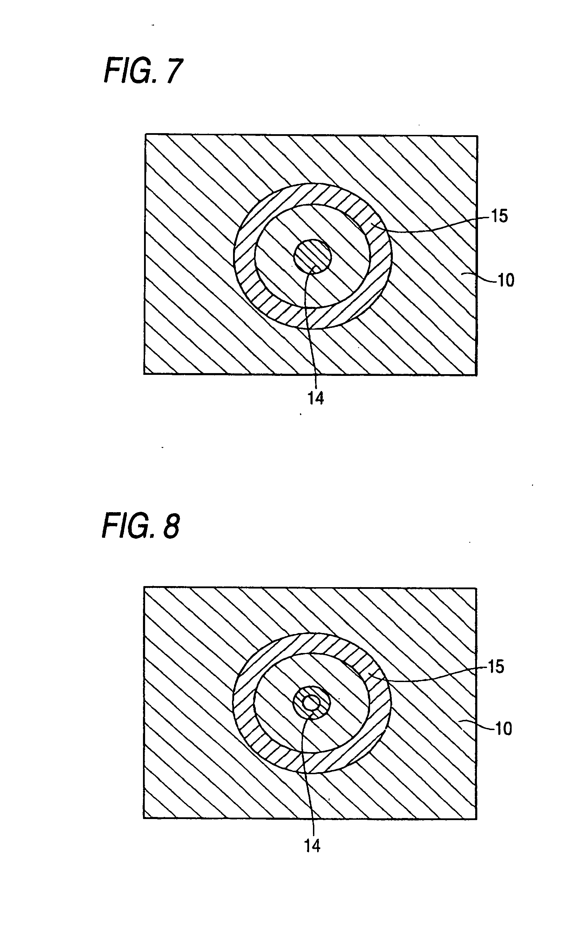

FIG. 7     is a cross sectional plan view taken on line B - B of FIG. 6D;

FIG. 8     is a cross sectional plan view showing the structure of a third embodiment of the TFT according to the invention;

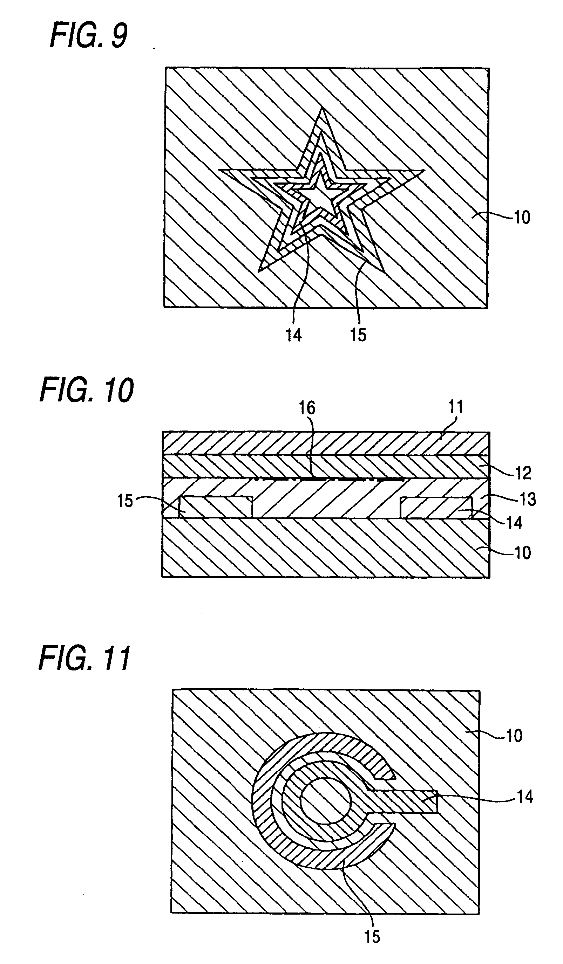

FIG. 9     is a cross sectional plan view showing the structure of a fourth embodiment of the TFT according to the invention;

FIG. 10     is a cross sectional view showing an example of a structure (top gate) of a related OTFT;

FIG. 11     is a cross sectional view showing the structure of the TFT of comparison example 2 to be put in contrast with example 4; and

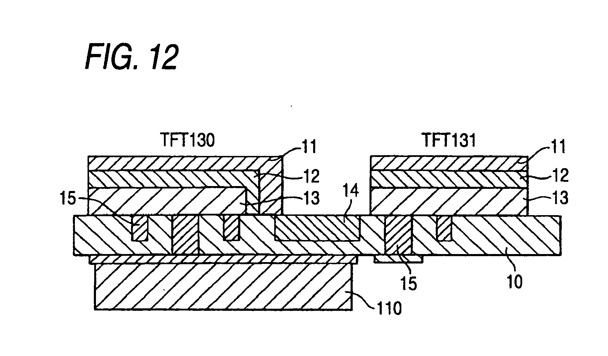

FIG. 12     is a cross sectional view showing the structure of the TFT of example 5.

Throughout the drawings the same constituents are denoted with the same reference numerals.

A transistor according to the invention is a thin film field-effect transistor in which a film of organic semiconductor material, a gate insulating film and a gate electrode are formed in lamination, the path of a current flowing between a source electrode and a drain electrode, both being formed separate from the lamination, is provided through the film of organic semiconductor material in contact with the gate insulating film, and the current is controlled by the electric potential of the gate electrode. Each of the source electrode and the drain electrode is buried in a groove or a hole formed in a substrate with the film of organic semiconductor material, gate insulating film and gate electrode formed thereon to form the transistor.

The grooves or the holes are preferably formed by thermal imprinting.

In the case of using thermoplastic material as the material of a substrate, a substrate formed with desired grooves may be fabricated also by a method such as extrusion, for example. In extrusion, however, a size of a substrate is limited by the dimension of a mold. Compared with this, thermal imprinting is a method in which an embossing die necessary for forming the grooves or the holes is pressed against a substrate heated up to a glass transition point or above. Therefore, there is basically no limitation in a size of a substrate, so that the method is suited for successively forming grooves on large size substrates.

For the material of a substrate, photo-setting resin can be also used. In thus case, after grooves or holes are formed on the resin by carrying out embossing, the resin is irradiated by light for setting, by which the grooves or the holes are provided. In this case, the resin generally lacks elasticity after being set. Therefore, when flexibility is required for the resin as a product, delicate care must be taken about the setting condition.

The heating temperature of the substrate when the grooves or the holes are formed is ordinarily 100°C to 300°C though the temperature depends on the substrate material being used.

A pressure applied to the substrate for forming the grooves or the holes is ordinarily 10 to 200MPa.

The material of the embossing die used for forming the grooves or the holes is not particularly limited. The materials are named materials such as silicon, silicon carbide, sapphire, diamond, tantalum, $SiO_2/Si$ and $SiN/Si$, for example. The embossing die is preferably heated prior to working with the heating temperature preferably being 100°C to 350°C.

The width of one of the grooves or the holes is ordinarily 10nm to 50$\mu$m though the width depends on the thickness of the embossing die.

With a manufacturing method of the TFT according to the invention, a TFT can be obtained with a substrate area of 100nm$^2$ or more, more preferably 1$\mu$m$^2$ or more.

The spacing between the grooves or the holes is equivalent to a channel length. According to the invention, the channel length can be provided as being 1 to 50$\mu$m. The preferable upper limit of the channel length is 30$\mu$m, and more preferably, 12$\mu$m.

The source electrode or the drain electrode is preferably formed by pouring solution of electrically conductive material or liquid dispersion of electrically conductive material in each of the grooves or the holes formed in the substrate. With the method, the solution or the liquid dispersion is well poured in the grooves or the holes by capillarity due to surface tension even when each of the grooves or the holes has a high aspect ratio. Thus, compared with other film forming measures, the electrodes can be easily formed. Moreover, it becomes possible to form the source electrode or the drain electrode inexpensively, with high accuracy and with well reproducibility without using such measures as highly expensive photolithography.

Moreover, the TFT according to the invention is preferably formed with at least one of the source electrode and the gate electrode penetrating the substrate to provide electrical connection on the substrate surface opposite to the substrate surface on which the film of organic semiconductor material, the gate insulating film and the gate electrode are presented. With such an arrangement, the wiring of the source electrode and the wiring of the drain electrode are separately provided on the respective surfaces of the substrate opposite to each other. This provides advantage of facilitating matrix-like wiring necessary for display driving. Namely, even with an arrangement in which a lead wire on the side of the source electrode of the TFT and the lead wire on the side of the drain electrode orthogonally intersect with each other, the wires are separately formed on the respective surfaces of the substrate opposite to each other. Thus, there is no necessity of forming an insulating film at the intersection of the wires. A particularly preferable embodiment is shown as a structure with one of the electrodes made to penetrate the substrate to be completely surrounded by the other electrode.

For the electrode made to penetrate the substrate, for ensuring electrical connection thereto, a supplementary electrode can be provided on the substrate surface opposite to the substrate surface on which the film of organic semiconductor material, the gate insulating film and the gate electrode are presented.

It is preferable that one of the source electrode and the drain electrode is formed along the outer periphery of the other electrode in the substrate surface.

In the specification, "to be formed along the outer periphery" means that at least a part of the contour of one of the electrodes is formed so as to surround a part of the contour of the other one of the electrodes with a certain distance apart therefrom.

Therefore, when it is said that one of the electrodes is formed along the outer periphery of the other electrode in the substrate surface, the case is not limited to one in which one of the electrodes is enclosed by the other electrode, but can be one in which two comb-shaped electrodes are formed opposite to each other so that each of the comb teeth of the one electrode is disposed in each of spaces between the comb teeth of the other electrode.

The TFT according to the invention is more preferably provided as one in which one of the source electrode and the drain electrode is surrounded by the other electrode.

For example, by forming the drain electrode in column-like and forming the source electrode in doughnut-like around the drain electrode, the source electrode can be made to have a function of a so-called guard ring to thereby suppress a leak current. However, for forming the doughnut-like electrode as a closed one surrounding the other electrode inside by means of photolithography, two times or more of exposure processes are necessary which are further accompanied with highly difficult processes such as pattern positioning. Compared with this, the thermal imprinting according to the invention is particularly preferable in that the pattern of the two electrodes can be formed by one time operation with no fear of causing displacement in relative position between the two electrodes.

A first embodiment of the TFT according to the invention is shown in FIGS. 1A to 1 D illustrating the structure and manufacturing steps thereof. A heated embossing die is pressed against a thermoplastic substrate 10 to form two grooves 20 (FIG. 1A). Thereafter, a solution of an electrically conductive material or a liquid dispersion of an electrically conductive material is applied to the substrate 10. The solution or the liquid dispersion is enters the grooves 20 by capillary action (FIG. 1 B). For facilitating this entering, it is possible to make the inside of the grooves 20 hydrophilic beforehand by ozone exposure processing or coating with various hydrophilic processing materials. After the solution or the liquid dispersion has dried and set up, the resulting electrically conductive material 21 outside the grooves is removed by oxygen plasma, by which a structure is formed in which a source electrode 15 and a drain electrode 14 are provided with a certain distance apart from each other (FIG. 1C).

In some cases, drying of the applied solution or the liquid dispersion causes shrinkage in volume thereof to produce a gap in the in the recess, the groove in this case or the hole of an embodiment described later. However, as long as an electrical connection is provided, no functional problem arises from such gap. When the gap must be filled in for other reasons, with the use of a solution with a relatively high concentration, a method such as that of repeating the application and drying of the solution a number of times can be used.

On the substrate 10 with the source electrode 15 and the drain electrode 14 formed thereon, a film of an organic semiconductor material 13, a gate insulating film 12 and a gate electrode 11 are formed in this order by a method such as vacuum evaporation, spin coating or printing (FIG. 1D). A channel 16 for carriers is formed in a region between the source electrode 15 and the drain electrode 14 in the film of organic semiconductor material 13 in the vicinity of the interface with the gate insulating film 12. In FIG. 5, a cross sectional plan view of the structure is shown which is taken on line A - A of FIG. 1 D.

Although the first embodiment has been described above with reference to grooves 20, it is likewise applicable to holes provided instead of the grooves.

FIGURES 6A to 6D are cross sectional views showing a second embodiment of the TFT according to the invention illustrating the structure and manufacturing steps thereof. FIGURE 7 is a cross sectional plan view taken on line B - B of FIG. 6D. In the second embodiment a cylinder-like hole 20 and a ring-like groove 20 surrounding the hole 20 are formed in a substrate 10 by the same method as that in the first embodiment (FIG. 6A). The hole 20 is formed deeper than the groove 20. Then, by the same method as that in the first embodiment, a solution of an electrically conductive material or a liquid dispersion of an electrically conductive material is poured into the hole 20 and the groove 20 to form a drain electrode 14 and a source electrode 15. The drain electrode 14 is formed to have a depth deeper than that of the source electrode 15 (FIG. 6B). Thereafter, almost simultaneously with the removal of electrically conductive material 21 on the substrate surface outside the groove and the hole, etching of the substrate surface opposite to that with the electrodes is carried out to thereby make the drain electrode 14 penetrate the substrate 10 to the opposite surface (FIG. 6C). After that, the film of organic semiconductor material 13, the gate insulating film 12 and the gate electrode 11 are formed in the same way as that in the first embodiment. About the drain electrode 14, an electrode 22 for ensuring electrical connection thereto on the opposite surface can be also formed as required (FIG. 6D).

In the second embodiment, the source electrode 15 is formed along the outer periphery of the drain electrode 14 to also play a role of a guard ring. Therefore, an arrangement is provided by which a leak current due to a drain voltage does hardly occur. Such an arrangement including grooves of closed curves can not be provided by a single process in a method using a mask such as photolithography because there is no supporting structure for a mask determining the inner contours of the grooves. Compared with this, the method according to the invention can easily provide such arrangement by a one time process when the embossing die for the arrangement has been prepared.

As a third embodiment, an arrangement as shown in FIG. 8 can be also easily provided in which a drain electrode 14 positioned inside a ring-shaped source electrode 15 is formed in a doughnut-like or ring-like shape like the source electrode 15 surrounding it. In this case, compared with the area of the hole for the drain electrode 14 shown in FIG. 7, the area of the groove for the drain electrode 14 becomes smaller to facilitate entering of a solution of electrically conductive material by capillary action. When the drain electrode 14 is made to penetrate the substrate 10, a structure is provided in which the substrate inside the drain electrode 14 is supported through the electrically conductive material of the drain electrode 14. Moreover, as a fourth embodiment, as shown in FIG. 9, an arrangement can of course be provided in which each of the plane shapes of the drain electrode 14 and the source electrode 15 is made to be an uncommon star-like shape for increasing the outer peripheral length thereof. This increases the channel length to increase the saturation current Isd of the transistor.

It is to be noted that as an alternative to what has been described before, the source electrodes in Figs. 5 and 7 to 9 could be the drain electrodes and the drain electrodes could be the source electrodes.

A comparison between the thus formed structures of a TFT according to the invention and element structures of the prior art, i.e., the bottom contact structure in FIG. 3, the top contact structure in FIG. 4 and the top gate structure in FIG. 10, reveals that the manufacturing method according to the invention has the following advantage: It requires less capital investment and facilitates the manufacturing process in contrast with each of the methods for the bottom contact structure and the top gate structure which require an expensive facility and a number of process steps because the source electrode and the drain electrode are formed by such a method as photolithography. This cost advantage becomes particularly remarkable when a fabrication that makes the channel length 10μm or less is carried out.

Moreover, since the source electrode and the drain electrode in the top contact structure are formed by originally using a shadow mask, it is difficult to form a channel length of 30μm or less.

Thus, the invention avoids the problems involved in prior art element structures and makes it possible to realize a high precision microfabrication by an inexpensive process.

As organic semiconductor materials, materials such as lubrene, thiophene, hexyl thiophene series polymer, fluorene/thiophene series polymer, copper phthalocyanine and fullerane are preferably used in the present invention, in addition to acene series compounds such as pentacene, tetracene and anthracene. These materials represent examples only and many other organic semiconductor materials are applicable as well. The particular organic semiconductor material is not critical to the present invention.

With respect to the source electrode and the drain electrode, various kinds of metallic materials and organic electrically conductive materials are applicable. When the majority carriers in the organic semiconductor material are holes, for example, a material with a large work function is suitable as electrode material to enhance the injection of holes at the source electrode and inhibit the injection of electrons at the drain electrode. In particular, as a metallic material, a material including fine particles of noble metal such as Au, Ag or Pt as the main ingredient, which is easily prepared as a liquid dispersion, is suitable. Moreover, as organic electrically conductive material, poly-3,4-ethylene dioxythiophene/polystylene-sulfonate (PEDOT/PSS) and polyaniline (PANI) are suitable.

As the material of the gate insulating film, various kinds of metallic oxides, oxides of metals such as silicon, aluminum, tantalum, titanium, strontium and barium, for example, and mixed oxides of the metallic oxides can be used. Moreover, macromolecular materials, for example, polymer materials such as polystyrene, polyvinyl alcohol, polyvinyl phenol and acrylic resin can be also used. Moreover, the macromolecular materials can be also used with metallic oxides dispersed therein. In particular, many metallic oxides have higher permittivities compared with those of macromolecular materials. Thus, a gate insulating film using such a metallic oxide is characterized by enabling a transistor to be driven by a relatively low voltage. While, macromolecular material has a relatively low permittivity. Thus, a gate insulating film using macromolecular material is characterized by enhancing a high speed response of a transistor.

With respect to the gate electrode, various kinds of metallic material and organic electrically conductive material are applicable. The material is determined by considering such items as adhesive properties to the gate insulating film and easiness in formation.

For the substrate on which the elements are formed, various kinds of material can be used. When the grooves or the holes are formed by thermal imprinting, a thermoplastic material is preferably used.

For such thermoplastic material, there is no limitation and polymer films of materials such as, for example, polyether imide (PEI), polyether etherketone (PEEK), polyethylene terephthalate (PET), polyethylene naphthalate (PEN), polyether sulfon (PES), polyphenylene sulfide (PPS), polycarbonate (PC), polystyrene (PS) and polymethyl methacrylate (PMMA) can be used.

The aspect ratio of the grooves or holes of the TFT according to the invention is preferably 1 to 40. The more preferable upper limit of the aspect ratio is 30 and the more preferable lower limit is 3.

In the following particular examples of the present invention will be explained, these examples being not intended to limit the invention in any way.

Example 1

A polyethylene naphthalate (PEN) substrate 10 (100μm in thickness) was heated to 220°C, into which a separately formed embossing die of silicon was pressed while being heated to 270°C to thereby form two grooves, each having a width of 20μm, a length of 100μm (corresponding to the channel width) and a depth of 60μm, at a distance of

10μm (corresponding to the channel length) from each other. The grooves were irradiated with ultraviolet light with a wavelength of 254nm to be made hydrophilic. Thereafter, a PEDOT/PSS solution ("A14083" produced by Bayer Ltd.) as a solution of electrically conductive material was applied to the surface of the substrate 10 by spin coating. The rotating speed and the rotating time in the spin coating were 1000rpm and 180 seconds, respectively. After the entrance of the applied PEDOT/PSS solution into the grooves by capillary action was confirmed, the applied solution was dried at 120°C for 10minutes.

Next to this, PEDOT/PSS outside the grooves was etched by oxygen plasma, by which electrical insulation between the two grooves was secured. At this time, conducting sections for obtaining electrical connection with an external circuit were retained by providing masks thereon for preventing these sections from being etched.

Following this, a thiophene series polymer and poly (3-hexyl thiophene) (P3HT) (produced by Merck Ltd.) were dissolved in p-xylene in concentration of 2mg/ml. By applying the thus prepared solution to the substrate 10 by spin coating, a film of organic semiconductor material 13 was obtained with a thickness of 30nm. Thereafter, polystyrene (produced by Aldoritch Ltd.) was dissolved in ethyl acetate in concentration of 70mg/ml. By applying the thus prepared solution to the film of organic semiconductor material 13 by spin coating, the gate insulating film 12 was obtained with a thickness of 300nm. Finally, by depositing aluminum on the polystyrene gate insulating film 12 by vacuum evaporation, the gate electrode 11 with a thickness of 60nm was obtained. In this way, a test sample of Example 1 was obtained.

Example 2

A substrate of a polyethylene naphthalate (PEN) sheet with a thickness of 100μm, having two grooves formed therein at a distance of 5μm (corresponding to the channel length) from each other, was prepared by extrusion. Each groove was formed to have a width of 20μm, a length of 100μm (corresponding to the channel width) and a depth of 60μm. Except for the use of thus prepared substrate, the same procedures as those in Example 1 were carried out, by which a test sample of Example 2 was obtained.

Example 3

Instead of the PEDOT/PSS solution, a liquid dispersion of fine Ag particles ("Nanometal Ink" produced by Shinku Yakin Co., Ltd.) was used in this case as for the electrically conductive material which was then dried at 150°C for 120 minutes. Except this difference and for etching of conducting sections other than the grooves and conducting sections for obtaining electrical connection with an external circuit having been carried out by using a diluted nitric acid, the same procedures as those in Example 1 were carried out, by which a test sample of Example 3 was obtained.

Example 4

A polyethylene naphthalate (PEN) substrate 10 (50μm in thickness) was heated to 200°C, and a separately formed embossing die of silicon was pressed into the substrate while being heated to 260°C, by which an inner circular groove with an inner diameter of 30μm, an outer diameter of 40μm and a depth of 30μm and an outer circular groove with an inner diameter of 50μm, an outer diameter of 60μm and a depth of 45μm were formed to be concentric. The distance of 10μm between the two circular grooves corresponds to the channel length and each of the circumferential lengths of the circles of the grooves (40μm and 50μm in terms of diameters) facing the channel correspond to channel widths. In the same way as in Example 1, the grooves were irradiated with ultraviolet light with a wavelength of 254nm to be made hydrophilic. Thereafter, a PEDOT/PSS solution ("A14083" produced by Bayer Ltd.) as a solution of electrically conductive material was applied to the surface of the substrate 10 by spin coating. After this, the opposite surface of the substrate was polished by oxygen plasma etching to make the outer groove, filled with the drain electrode 14, penetrate the substrate. Following this, in the same way as in Example 1, a thiophene series polymer and poly (3-hexyl thiophene) (P3HT) (produced by Merck Ltd.) were dissolved in p-xylene in concentration of 2mg/ml. By applying the thus prepared solution to the substrate 10 by spin coating, the film of organic semiconductor material 13 with a thickness of 30nm was obtained. Thereafter, polystyrene (produced by Aldoritch Ltd.) was dissolved in ethyl acetate in concentration of 70mg/ml. By applying the thus prepared solution to the film of organic semiconductor material 13 by spin coating, the gate insulating film 12 with a thickness of 300nm was obtained. Finally, by depositing aluminum on the polystyrene gate insulating film 12 by vacuum evaporation, the gate electrode 11 with a thickness of 60nm was formed. In this way, a test sample of Example 4 was obtained.

Example 5

By the same method as in Example 4, 100 combinations each including two TFTs were formed in a matrix of 10 rows by 10 columns. To the two TFTs, a driving TFT 130 and a switching TFT 131, in each combination, a capacitor 106 and a light-emitting element (an organic EL (electroluminescent) element) 110 were added, respectively, to form a light-emitting element control circuit as shown in FIG. 2. Moreover, as shown in a cross-sectional view in FIG. 12 in the structure of each combination, the gate electrode 11 of each of the driving TFT 130 and the switching TFT 131 was formed on the same side of the substrate 10. Furthermore, in the switching TFT 131, an electrode penetrating the substrate was used as the source electrode 15 and an outer electrode surrounding the source electrode 15 was used as the drain electrode 14. In this way, a first row electrode 103, a second row electrode 104 and a capacitor 106 shown in FIG. 2 were placed on the side of the gate electrodes 11 of the TFTs 130 and 131. Moreover, a light-emitting element 110, a first column electrode 116 and a second column electrode 117 were placed on the substrate surface on the opposite side of the gate electrodes 11 (in FIG. 12, illustration of constituents other than the TFTs 131 and 132 and the light-emitting element 110 are omitted).

Comparison Example 1

An element having a structure similar to that of the element in Example 1 was formed in a top gate structure of the prior art by using photolithography. Namely, a photoresist ("OFPR-800" produced by Tokyo Ohka Kogyo Co., Ltd.) was applied to a substrate with a thickness of $2\mu m$ by spin coating. Thereafter, the applied photoresist was irradiated through a photomask with ultraviolet light with a wavelength of 405nm and a power density of 11 mW/cm$^2$ for 4 seconds to set the irradiated section. At the respective sections at which a source electrode and a drain electrode were to be formed, two images of shadows, at which no ultraviolet light was projected and each of which had a width of $20\mu m$ and a length of $100\mu m$, were formed at a distance of $10\mu m$ (corresponding to the channel length) from each other. After this, with the use of a developing solution ("NMD-3"=produced by Tokyo Ohka Kogyo Co., Ltd.), development was carried out with the sections not irradiated with ultraviolet light washed away. Then, prebake (at 110°C for 90 seconds) and post bake (at 130°C for 30 minutes) were carried out. On the thus processed element, a gold thin film with a thickness of 100nm was formed by vacuum evaporation. Furthermore, after the photoresist was stripped off by the lift-off method, the exposed substrate surface was irradiated with ultraviolet light with a wavelength of 254nm to be cleaned. On the cleaned substrate surface, a poly (3-hexyl thiophene) (P3HT) (produced by Merck Ltd.) thin film as the film of organic semiconductor material 13, a polystyrene thin film as the gate insulating film 12 and an aluminum thin film as the gate electrode 11 were formed in the same way as in example 1. Thus, a test sample of Comparison Example 1 was obtained.

Comparison Example 2

A test sample having an arrangement similar to that in Example 4 was fabricated with a prior art structure on a substrate surface. Namely, on a polyethylene terephthalate (PET) substrate 10 ($50\mu m$ in thickness), a doughnut-like inside electrode with an inner diameter of $30\mu m$ and an outer diameter of $40\mu m$ was formed as a drain electrode 14. Together with this, a doughnut-like outside electrode with an inner diameter of $50\mu m$ and an outer diameter of $60\mu m$ was formed as a source electrode 15. Both of the doughnut-like electrodes were formed by a method like that in Comparison Example 1. Both electrodes were formed on the same plane. Thus, the necessity for providing the inside drain electrode 14 with electrical connection to the outside caused the outside source electrode 15 to have a C-like shape with a cut-out in a part thereof as shown in FIG. 11.

The characteristics of the test sample elements of the foregoing examples and the comparison examples are summarized in Table 1. The elements in Example 1, Example 2 and Example 3 have approximately equal values of mobility and saturation current Isd (Vg = -20V) compared with those of the elements in Comparison Example 1 (the element in example 2 has a value of W/L two times that of the elements in Example 1, Example 3 and Comparison Example 1, which makes the element in Example 2 have a value of the saturation current Isd also becoming two times those of the elements in Example 1, Example 3 and Comparison Example 1). Leak currents of the elements of Examples 1, 2 and 3 are also equal to that of Comparison Example 1. However, in the elements in each of Examples 1, 2 and 3, the standard deviation of Isd of fabricated 100 elements becomes slightly smaller with significantly reduced working hours (the time required for fabricating 100 elements). This is because the formation of the source electrode 15 and the drain electrode 14 requires a process of only three steps with each being facilitated for each of the elements in Example 1 and Example 2 compared with a process of as many as eight steps for the element in Comparison Example 1. The three steps for each of the elements in Example 1 and Example 2 are the steps of (1) forming grooves in a substrate, (2) applying electrically conductive material and (3) carrying out etching. While, the eight steps for the elements in Comparison Example 1 are the steps of (1) applying a photoresist, (2) projecting ultraviolet light, (3) carrying out development, (4) carrying out pre-bake, (5) carrying out post-bake, (6) forming a gold thin film by vacuum evaporation, (7) carrying out photoresist liftoff and (8) cleaning the substrate.

As regards the element of Example 4, the working hours thereof are significantly shortened compared with those for the element of Comparison Example 2. In addition to this, the leak current is largely reduced compared with that of the element in Comparison Example 2. This is probably due to an imperfect guard ring effect by the source electrode 15 on the drain electrode 14 in the case of the element of Comparison Example 2.

In Example 5, an intersection of row electrodes and column electrodes on the substrate could be avoided to facilitate the fabrication process. In addition to this, there was a reduction in the number of elements formed on the substrate surface on which the light-emitting elements were to be formed. This enabled an increase in area ratio of the light-emitting element.

Table 1

| | W/L (μm/μm) | Averaged value of mobility (cm2/Vs) | Averaged value of Isd (μA) | Standard deviation of Isd (%) | Leak current (nA) | Working hours (Relative value) |
|---|---|---|---|---|---|---|
| Example 1 | 100/10 | 0.021 | 0.34 | 2.5 | 0.32 | 10 |
| Example 2 | 100/5 | 0.018 | 0.59 | 1.3 | 0.54 | 7 |
| Example 3 | 100/10 | 0.023 | 0.36 | 2.7 | 0.47 | 11 |
| Example 4 | 125/10 | 0.017 | 0.34 | 3.0 | 0.02 | 18 |
| Comparison Example 1 | 100/10 | 0.02 | 0.32 | 4.6 | 0.58 | 65 |
| Comparison Example 2 | 120/10 | 0.019 | 0.37 | 4.1 | 0.10 | 72 |

As explained in the foregoing, the present invention allows an OTFT realization by means of a high precision microfabrication of a source electrode and a drain electrode formed on a substrate such as a plastic substrate by an inexpensive process for stable realization of high performance. In addition, it facilitates a matrix-like wiring to the source electrode and the drain electrode and reduces a leak current from the element of the transistor.

**Claims**

1. A thin film transistor including:

   a substrate (10);
   a source electrode (15);
   a drain electrode (14);
   a film (13) of organic semiconductor material formed on the source electrode (15) and the drain electrode (14) for making electrical contact therewith;
   a gate insulating film (12) formed on the film (13) of organic semiconductor material; and
   a gate electrode (11) formed on the gate insulating film (12)
   **characterized in that**
   two recesses (20) are provided in a surface of the substrate (10), one recess (20) being a groove and the other recess (20) being either another groove or a hole, the source electrode (15) fills one of the recesses (20) and the drain electrode (14) fills the other recess (20).

2. The thin film transistor as claimed in claim 1 wherein the substrate (10) is made of thermoplastic material.

3. The thin film transistor as claimed in claim 1 or 2 wherein the source electrode (15) and/or the drain electrode (14) penetrates the substrate (10).

4. The thin film transistor as claimed in any one of claim 1 to 3 wherein one electrode of the source electrode (15) and the drain electrode (14) is formed along the outer periphery of the other electrode in the surface of the substrate (10).

5. The thin film transistor as claimed in claim 4 wherein one electrode of the source electrode (15) and the drain electrode (14) is surrounded by the other electrode.

6. The thin film transistor as claimed in claim 4 wherein each of the source electrode (15) and the drain electrode (14) has a comb-shaped structure and is formed opposite to the other electrode in the surface of the substrate (10) so that each comb tooth of the one electrode is disposed within the space between two corresponding comb teeth of the other electrode.

7.  A method of manufacturing a thin film transistor including the steps of:

a) providing a substrate (10);
b) forming one of a source electrode (15) and a drain electrode (14) on the substrate (10);
c) forming the other one of the source electrode (15) and the drain electrode (14) on the substrate (10); and
d) forming a film (13) of organic semiconductor material, a gate insulating film (12), and a gate electrode (11) in this order on the substrate (10) with the source electrode (15) and the drain electrode (14) formed thereon;

**characterized in that**

step a) comprises forming two recesses (20) in the substrate (10), one recess (20) being a groove and the other recess (20) being either another groove or a hole;
step b) comprises forming the source electrode (15) in one of the recesses (20) in the substrate (10) surface; and
step c) comprises forming the drain electrode (14) in the other recesses (20) in the substrate (10).

8.  The method as claimed in claim 7 wherein step a) comprises forming the recesses (20) in the substrate (10) surface by thermal imprinting.

9.  The method as claimed in claim 7 or 8 wherein step b) and/or step c) comprises applying a solution of electrically conductive material or a liquid dispersion of electrically conductive material onto the surface of the substrate (10) and have it enter the respective recess (20) in the surface of the substrate (10).

10.  The method as claimed in claim 9, wherein steps b) and c) are performed in one step.

*FIG. 1A*

*FIG. 1B*

*FIG. 1C*

*FIG. 1D*

## FIG. 2

Y1 117 · 116 Y2 103

110

ORGANIC EL

131 X3

TFT

TFT 130

C

106

X4 104

## FIG. 3

16 · 14 · 13

15

12

11

10

## FIG. 4

15 · 16 · 13 · 14

12

11

10

FIG. 5

FIG. 6A

FIG. 6B

FIG. 6C

FIG. 6D

*FIG. 7*

*FIG. 8*

## FIG. 9

10

14   15

## FIG. 10

16   11

12

15   13

14

10

## FIG. 11

10

14

15

FIG. 12

TFT130    ——11

——12

15 ——    ——13

14

TFT131    ——11

——12

——13

15    10

——110

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001250680 A
- WO 0115233 A